(19) **Europäisches Patentamt / European Patent Office / Office européen des brevets**

(11) **EP 2 691 977 B1**

(12) **EUROPEAN PATENT SPECIFICATION**

(45) Date of publication and mention
of the grant of the patent:
**05.06.2019 Bulletin 2019/23**

(21) Application number: **12714271.9**

(22) Date of filing: **29.03.2012**

(51) Int Cl.:
*H01L 21/205* (2006.01)    *H01L 31/02* (2006.01)
*H01L 31/048* (2014.01)    *H01L 31/055* (2014.01)

(86) International application number:
**PCT/EP2012/055620**

(87) International publication number:
**WO 2012/130933 (04.10.2012 Gazette 2012/40)**

(54) **METHOD FOR GROWING A MONOCRYSTALLINE TIN-CONTAINING SEMICONDUCTOR MATERIAL**

VERFAHREN ZUR HERSTELLUNG EINES MONOKRISTALLINEN ZINNHALTIGEN HALBLEITERMATERIALS

PROCÉDÉ DE CROISSANCE DE MATÉRIAU SEMI-CONDUCTEUR CONTENANT DE L'ÉTAIN MONOCRISTALLIN

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2011 US 201161470442 P**

(43) Date of publication of application:
**05.02.2014 Bulletin 2014/06**

(73) Proprietors:
• **IMEC VZW**
  **3001 Leuven (BE)**
• **Katholieke Universiteit Leuven**
  **3000 Leuven (BE)**

(72) Inventors:
• **VINCENT, Benjamin**
  **B-3001 Leuven (BE)**

• **GENCARELLI, Federica**
  **B-3001 Leuven (BE)**
• **LOO, Roger**
  **B-3001 Leuven (BE)**
• **CAYMAX, Matty**
  **B-3001 Leuven (BE)**

(74) Representative: **Hertoghe, Kris Angèle Louisa**
  **DenK iP bvba**
  **Hundelgemsesteenweg 1116**
  **9820 Merelbeke (BE)**

(56) References cited:
**EP-A2- 0 327 034        EP-A2- 2 477 211**
**WO-A2-2005/087983    US-A- 3 312 570**
**US-A- 3 836 999          US-A1- 2006 163 612**

**Description**

**FIELD OF THE INVENTION**

The present invention relates to methods for manufacturing semiconductor material, more particularly to methods for providing monocrystalline semiconductor material, in particular tin-containing semiconductor material like tin germanides (GeSn) and tin silicon-germanides (SiGeSn), onto a substrate, and to layers and stacks of layers thus obtained. In particular the present invention also relates to the use of tin tetrachloride ($SnCl_4$) as Sn-precursor for chemical vapor deposition of Sn comprising semiconductor materials.

**BACKGROUND OF THE INVENTION**

There is a growing interest in tin-containing semiconductor materials like tin germanides (GeSn) and tin silicon-germanides (SiGeSn) for many applications, such as high mobility channel and strain engineering for advanced microelectronic devices, direct bandgap Group IV materials for photonic devices or SiGeSn alloys for photovoltaic devices.

Tin (Sn) has very low equilibrium solubility in Ge (less than 1 at%) and above this concentration tends to segregate. Although it is possible to deposit GeSn with high non-substitutional Sn content, the percentage of substitutional Sn is limited as the solubility limit is very low. Therefore, non-equilibrium deposition techniques need to be developed choosing carefully the best precursors for both Ge and Sn to achieve sufficient incorporation of Sn in Ge and to obtain a high crystalline quality material at an acceptable growth rate.

For example, it is known that GeSn with a Sn content higher than 20 at% can be grown by Molecular Beam Epitaxy (MBE), which is a low throughput and expensive technique and therefore not advantageous for industrial applications.

Alternatively, GeSn with a Sn content up to 20 at% can be grown by ultrahigh vacuum chemical vapor deposition (UHV-CVD) using digermane ($Ge_2H_6$) as germanium precursor and perdeuterated stannane ($SnD_4$) as tin precursor. However, $SnD_4$ is a very unstable and expensive precursor, not suited for high volume manufacturing.

WO2005/087983 discloses deposition of silicon compounds and alloys by using various reactive gases, e.g. germanes and $SnCl_4$, and their mixtures.

US2006/163612 discloses the growth of a GeSnSi layer on a GeSn buffer layer.

**SUMMARY OF THE INVENTION**

It is an object of embodiments of the present invention to provide an efficient method for providing Sn-containing semiconductor material onto a substrate.

This objective is accomplished by a method according to claim 1.

The present invention provides a method for depositing a monocrystalline Sn-containing semiconductor material on a substrate. The method comprises providing a semiconductor material precursor, a Sn precursor and a carrier gas in a chemical vapor deposition (CVD) reactor, and epitaxially growing the Sn-containing semiconductor material on the substrate. The Sn precursor comprises tin tetrachloride (SnCl4). It is an advantage of embodiments of the present invention that an efficient method is provided for providing Sn-containing semiconductor material onto a substrate.

The Sn precursor is provided at a partial pressure of the Sn precursor in the CVD reactor lower than the partial pressure of the Sn-precursor at which no growth occurs anymore or even the substrate or an upper layer thereof starts to be etched.

In a method according to embodiments of the present invention, providing a Sn precursor may comprise providing the Sn precursor at a partial pressure in the CVD reactor, whereby for a selected total pressure in the CVD reactor the partial pressure of the Sn precursor may be adjusted by modifying at least one of the semiconductor material precursor flow, the Sn precursor flow or the carrier gas flow in the CVD reactor. Adjusting the partial pressure of the Sn precursor adjusts the growth rate of the Sn containing material.

When providing a semiconductor material precursor, a Sn precursor and a carrier gas in a chemical vapor deposition (CVD) reactor a selected total pressure in the CVD reactor may be lower than or equal to atmospheric pressure.

Providing a semiconductor material precursor may comprise providing digermane, trigermane or any high order germanium precursor and/or any combinations thereof. In particular embodiments, especially for example in case of the selected total pressure in the CVD reactor being atmospheric pressure, a ratio between $SnCl_4$ flow and $Ge_2H_6$ flow may be equal to or lower than 0.2, for example between 0.2 and 0.1, or even below 0.1. In alternative embodiments, where the pressure in the reactor is selected below atmospheric pressure, for example about 100 Torr, a ratio between $SnCl_4$ flow and $Ge_2H_6$ flow may be closer to 1, e.g. between 0.8 and 1.0. The latter gives better Sn-containing material properties.

In a method according to embodiments of the present invention, providing a semiconductor material precursor may further comprise providing a silicon precursor. This way, silicon containing material may be grown.

In a method according to embodiments of the present invention, the epitaxial growth may be performed at a temperature between 250°C and 350°C.

A method according to embodiments of the present invention may further comprise, during or after the epitaxial growth, introducing dopants in the Sn-containing semiconductor material. This way, properties, e.g. electrical properties, of the Sn-containing material may be changed.

The substrate comprises a Ge buffer layer, and epitaxially growing the Sn-containing semiconductor material comprises growing the Sn-containing semiconductor material onto the buffer layer.

The above and other aspects of the invention will be apparent from and elucidated with reference to the embodiment(s) described hereinafter.

## BRIEF DESCRIPTION OF THE DRAWINGS

The invention will now be described further, by way of example, with reference to the accompanying drawings. All drawings are intended to illustrate some aspects and embodiments of the present invention. The drawings described are only schematic and are non-limiting.

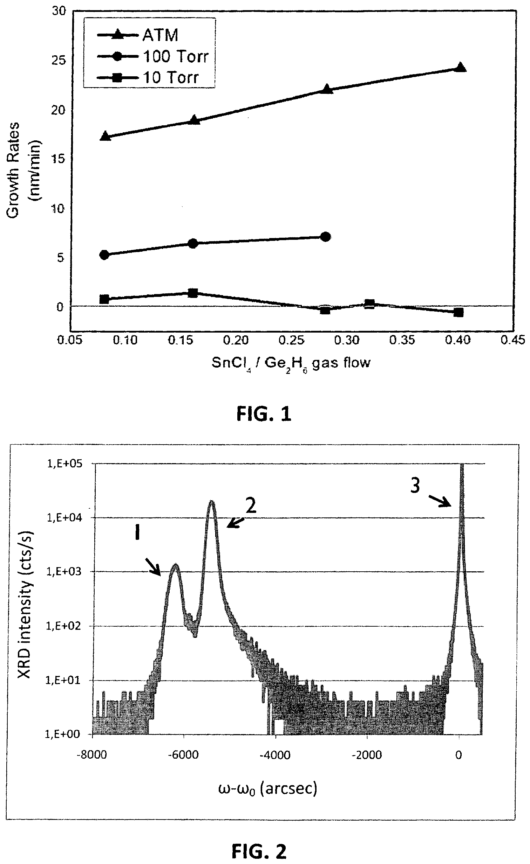

FIG. 1 shows the growth rate of epitaxially grown GeSn as function of the ratio ($SnCl_4$ flow)/($Ge_2H_6$ flow) at 320°C and at different total pressures in the reactor (reduced pressure: 10 Torr, 100 Torr; atmospheric pressure-ATM).

FIG. 2 shows the X-ray diffraction (XRD) pattern intensity of a monocrystalline GeSn layer epitaxially grown on a Ge buffer layer on a silicon substrate; (1) GeSn-peak, (2) Ge-peak, (3) Si -peak. The growth is performed at 320°C, at a reactor pressure of 10 Torr, with a $Ge_2H_6$ flow of 250 sccm; a $SnCl_4$ flow of 40 sccm and a $H_2$ flow of 20 slm.

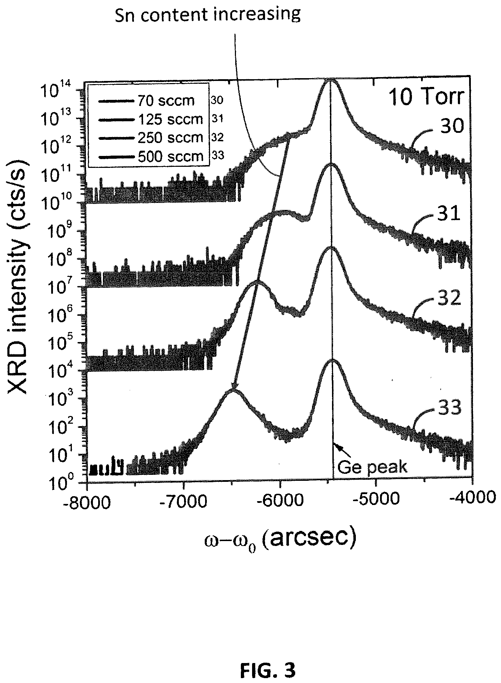

FIG. 3 shows the XRD pattern intensities of monocrystalline GeSn layers epitaxially grown on a Ge buffer layer on a silicon substrate. The GeSn layers were grown with a $SnCl_4$ flow of 40 sccm (Standard Cubic Centimeters per Minute) at a total pressure in the reactor of 10 Torr, at 320°C, with different $Ge_2H_6$ flows: (1) 70 sccm, (2) 125 sccm, (3) 250 sccm, (4) 500 sccm.

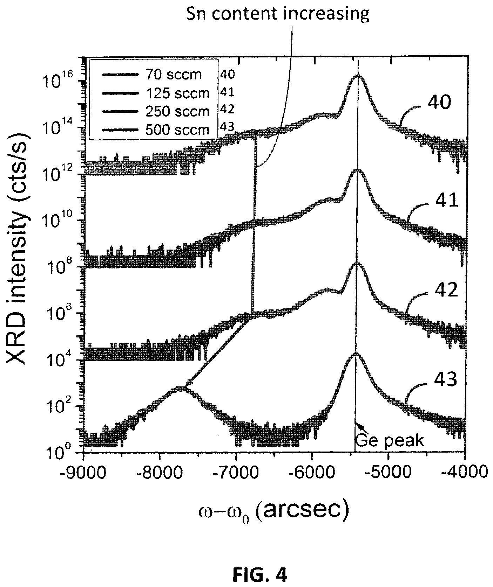

FIG. 4 shows the XRD pattern intensities of monocrystalline GeSn layers epitaxially grown on a Ge buffer layer on a silicon substrate. The GeSn layers were grown with a $SnCl_4$ flow of 40 sccm at a total pressure in the reactor of 1 ATM, at 320°C, with different $Ge_2H_6$ flows: (1) 70 sccm, (2) 125 sccm, (3) 250 sccm, (4) 500 sccm.

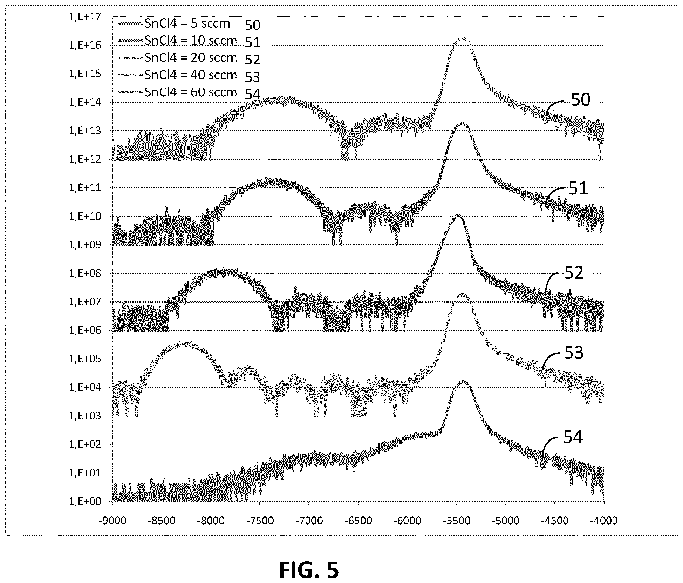

FIG. 5 shows the XRD pattern intensities of monocrystalline GeSn layers epitaxially grown on a Ge buffer layer on a silicon substrate. The GeSn layers were grown with a $Ge_2H_6$ flow of 500 sccm at a total pressure in the reactor of 1 ATM, at 320°C, with different $SnCl_4$ flows: (1) 5 sccm; (2) 10 sccm; (3) 20 sccm; (4) 40 sccm; (5) 60 sccm.

## DETAILED DESCRIPTION OF ILLUSTRATIVE EMBODIMENTS

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being re-defined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

Embodiments of the present invention relate to a deposition method of tin (Sn)- containing semiconductor materials by chemical vapor deposition (CVD).

Further, embodiments of the present invention also relate to the use of tin tetrachloride (SnCl$_4$) as tin precursor in the chemical vapor deposition process of Sn- containing semiconductor materials.

Embodiments of the present invention also relate to a monocrystalline Sn-containing semiconductor material such as GeSn or SiGeSn with Sn incorporated in substitutional positions in the lattice.

Furthermore, embodiments of the present invention relate to microelectronic or optoelectronic devices comprising layers of Sn-containing semiconductor material or stacks thereof, wherein the Sn-containing semiconductor material is un-doped or doped with n-type or p-type dopants.

In a first aspect of the invention a method for depositing a monocrystalline Sn-containing semiconductor material on a substrate is disclosed, comprising the steps of: providing a semiconductor material precursor, a Sn precursor and a carrier gas in a chemical vapor deposition (CVD) reactor, and epitaxially growing the Sn-containing semiconductor material on the substrate, wherein the Sn precursor comprises tin tetrachloride (SnCl$_4$).

The semiconductor material precursor may for example be a silicon precursor like silane (SiH$_4$), disilane (Si$_2$H$_6$), trisilane (Si$_3$H$_8$) or any other high order silane; or a germanium precursor like germane (GeH$_4$), digermane (Ge$_2$H$_6$), trigermane (Ge$_3$H$_8$) or any high order germanium precursor; a binary silicon-germanium precursor; or any combinations thereof. Additionally a carrier gas may be supplied directly to the CVD reactor. The carrier gas may for example be hydrogen (H$_2$), N$_2$ or a nobel gas such as He, Ar, Ne.

In embodiments of the invention, epitaxially growing the Sn-containing semiconductor material on the substrate may be performed in the CVD reactor which is held at a pre-determined pressure. At that particular reactor pressure, which may be atmospheric pressure or lower, the gasses provided in the CVD reactor, e.g. the semiconductor material precursor, the Sn precursor and the carrier gas, each take on a partial pressure. In accordance with embodiments of the present invention, the pressures are selected such that a partial pressure of the Sn precursor in the CVD reactor is lower than an etching threshold. The etching threshold is the partial pressure of the Sn-precursor in the presence of a semiconductor material precursor in the CVD reactor at which no deposition takes place, or even the substrate or the upper (buffer) layer of the substrate starts to be etched (consumed). When no reacting gases such as the semiconductor material precursors and/or the Sn precursor are present in the CVD reactor the etching threshold is close to zero. Most probably the etching of the substrate is due to the chlorine present in the Sn precursor and its reaction with the substrate (or upper/buffer layer). This etching behavior can also be due to a chlorine passivation of the substrate which makes further growth impossible. Alternatively worded, the ratio between the Sn precursor containing Cl and the Ge precursor must be below a predetermined threshold to be able to grow a GeSn alloy; if the ratio is above that threshold, no GeSn can be grown.

In general, the flow rates of the carrier gas and the precursor gas in the CVD reactor determine the partial pressure of the precursor gas in the mixture by the formula:

$$(1) \qquad p_p = \frac{FR_p}{\sum F} * p_{tot}$$

with: $p_p$ the partial pressure of the precursor gas, FRp the flow rate of the precursor gas (taking into account precursor

dilution), $\sum F$ is the sum of all the flows in the chamber (all precursor gases + carrier gas), $p_{tot}$ the total pressure in the reactor. Said total pressure may be atmospheric pressure or lower than atmospheric pressure. The application of the method according to embodiments of the present invention at atmospheric pressure offers the advantage that higher partial pressures can be obtained for the same flow rates. Higher partial pressures allow to speed up the growth, or to provide (and incorporate) more Sn in the layer being grown.

For a selected value of the total pressure in the CVD reactor, called the pre-determined reactor pressure hereinabove, the partial pressure of the Sn precursor may be adjusted by modifying at least one of the semiconductor material precursor flow, Sn precursor flow or carrier gas flow in the CVD reactor. The partial pressure of the Sn precursor may for example be lowered by reducing the Sn precursor flow, and/or by increasing one or more of the flows of the other precursors or carrier gases.

Typically the $SnCl_4$ precursor is in a liquid phase. It may be contained in bubbler which is connected at a carrier gas supply (e.g. $H_2$) and at the CVD reactor via a mass flow controller (MFC). A carrier gas such as $H_2$, $N_2$ or a noble gas is then bubbled through the $SnCl_4$ liquid thereby forming a $SnCl_4$ gas flow that is supplied to the CVD reactor. In particular embodiments of the invention $H_2$ is bubbled through the $SnCl_4$ liquid precursor.

Throughout this description the "$SnCl_4$ gas flow" is the total flow ($F_{cabinet}$) in the mass flow controller, i.e. the total flow of the mixture of carrier gas, e.g. $H_2$, and $SnCl_4$ supplied to the CVD reactor.

The actual flow of $SnCl_4$ ($F_{SnCl4}$) can be calculated with the formula

$$(2) \qquad F_{SnCl4} = F_{cabinet} \times \frac{P_{vap}^{SnCl4}}{P_{bubbler}}$$

wherein $p_{vap}^{SnCl4}$ is the vapor pressure of $SnCl_4$ in the bubbler at the temperature of the bubbler (in specific examples for example at 17°C) and the $p_{bubbler}$ is the pressure in the bubbler (in specific examples for example 1000 mbar).

Consequently, the partial pressure $p_{partial}^{SnCl4}$ of the $SnCl_4$ precursor in the CVD reactor is given by the formula

$$(3) \qquad P_{partial}^{SnCl4} = \frac{F_{SnCl4}}{F_{tot}} \times P_{tot} = \frac{F_{cabinet} \times P_{vap}^{SnCl4} \times P_{tot}}{F_{tot} \times P_{bubbler}}$$

wherein $F_{tot}$ is the sum of all the flows in the chamber (all precursor gases + carrier gas), $p_{tot}$ is the total pressure in the reactor as already defined in relation to formula (1).

In embodiments of the invention the total pressure in the CVD reactor is lower than or equal to atmospheric pressure. Throughout the present disclosure, reduced pressure CVD refers to a deposition process in accordance with embodiments of the present invention performed at a total pressure in the reactor between 5 and 300 Torr, more preferably between 5 and 100 Torr, even more preferably between 10 and 40 Torr.

In some embodiments of the invention the total pressure in the CVD reactor is equal to atmospheric pressure (1 ATM = 760 Torr = $1 \times 10^5$ Pa).

When a high order precursor of Ge is used; e.g. digermane, trigermane, ..., the epitaxial growth may be performed at a low temperature, for example a temperature between 250°C and 350°C, such as between 275°C and 320°C. However, depending on the semiconductor material precursor, the method of the invention can be performed also at higher temperatures up to about 600°C. At too low temperatures, the gases do not decompose so there is no growth, while at too high temperatures, GeSn is instable and Sn will segregate.

In specific embodiments, partial pressures of the Sn-precursor below the etching threshold corresponding to a total pressure in the reactor lower than or equal to atmospheric pressure and a ratio between $SnCl_4$ flow and $Ge_2H_6$ flow lower than 0.2, for example lower than 0.1, are disclosed. In alternative embodiments, for a total pressure in the reactor below atmospheric pressure, e.g. at 100 Torr, the ratio between $SnCl_4$ flow and $Ge_2H_6$ may be closer to 1, e.g. between 0.8 and 1.0. This higher ratio gives better cystallinity, hence better quality GeSn.

In particular embodiments dopants may be introduced in the Sn-containing semiconductor material either during or after the epitaxial growth.

In embodiments of the invention the substrate may comprise a semiconductor material or other material compatible with semiconductor manufacturing. The substrate can for example comprise silicon, germanium, silicon germanium, III-V compounds materials.

In some embodiments the substrate may comprise a buffer layer, exposed at the top surface, whereupon the Sn-containing semiconductor material is epitaxially grown.

In particular embodiments, the buffer layer comprises the same semiconductor material as the epitaxially grown Sn-containing semiconductor material. The buffer layer can comprise semiconductor materials like silicon, germanium, silicon germanium, III-V compound materials, as well as strained or doped versions thereof. The buffer can comprise multiple layers of semiconductor materials, such as (strained) germanium on top of a SiGe-strained relaxed buffer layer.

The claimed method provides a layer of monocrystalline Sn-containing semiconductor material whereby Sn is substitutionally incorporated in the semiconductor material. The substitutional incorporation of Sn into the semiconductor material is a desired feature for applications such as band gap engineering and strain engineering. With prior art methods such Sn incorporation is not straightforward; Sn incorporation into e.g. Ge lattice is not easy e.g. due to the large (about 17%) lattice mismatch between elements.

Further, a stack of layers comprising a plurality of layers of monocrystalline Sn-containing semiconductor material grown with a method according to the first aspect of the invention is described. At least one of the layers of monocrystalline Sn-containing semiconductor material may comprise dopants. The dopant concentration within the layers of monocrystalline Sn-containing semiconductor material may either be constant or variable, having a dopants concentration profile. Two layers in the plurality of layers can have a same Sn concentration or different Sn concentrations. Also layers of monocrystalline Sn-containing semiconductor material with variable (graded) Sn concentration can be manufactured with a method according to embodiments of the present invention. Different concentrations can for example be obtained by changing process conditions (temperature, pressure, gas flows). Such changing process conditions may modify both growth rate and Sn incorporation.

In a particular embodiment, a stack of layers comprising a layer of p-doped Ge underlying and in contact with a layer of intrinsic GeSn, at its turn underlying and in contact with a layer of n-doped Ge is disclosed. This stack of layers is suitable for manufacturing light-emitting diodes (LEDs). The layer of intrinsic GeSn may be grown by means of a method according to embodiments of the present invention.

In particular embodiments wherein the stack of layers is part of an optical device, a p-type doped/ intrinsic/ n-type doped stack of layers of monocrystalline Sn-containing semiconductor material is disclosed. Additional, graded or non-uniform doping profiles can be defined in the Sn-containing semiconductor material during the epitaxial growth to manufacture implant free quantum well devices.

The invention provides a stack of layers comprising a substrate, a buffer layer overlying the substrate and a layer of monocrystalline Sn-containing semiconductor material grown according to method embodiments of the present invention, overlying and in contact with the buffer layer. The buffer layer is a Ge buffer layer and the layer of monocrystalline Sn-containing semiconductor material comprises GeSn.

A layer or a stack of layers comprising a monocrystalline Sn-containing semiconductor material grown according to method embodiments of the present invention can be comprised in a high mobility channel device, photonic device, or a photovoltaic device.

The present invention relates to a deposition method of tin germanide (GeSn) by chemical vapor deposition using digermane ($Ge_2H_6$) as germanium precursor and tin tetrachloride ($SnCl_4$) as tin precursor at low deposition temperatures. In particular, the low deposition temperature refers to temperatures in the reactor between 250°C and 350°C, more preferably between 275°C and 320°C.

In particular embodiments the semiconductor material precursor may comprise a silicon precursor (e.g. silane, disilane, trisilane, or any other high order silane) in combination with a germanium precursor and tin tetrachloride to grow tin silicon-germanide (SiGeSn). Alternatively, binary silicon-germanium precursors known as germyl-silanes ($H_3GeSiH_3$, $(GeH_3)_2SiH_2$, $(H_3Ge)_3SiH$, $(H_3Ge)_4Si$) and tin tetrachloride can be used to grow tin silicon-germanide.

The chemical vapor deposition process can be performed in any manufacturing compatible CVD tool (reactor). The CVD reactor can be operated at reduced pressure, typically as from about 5 Torr, or at atmospheric pressure. Throughout the description, the pressure in the CVD reactor is referred to as the 'total pressure in the reactor'.

In the examples where digermane is used as germanium precursor, diluted digermane with a dilution of 1% in $H_2$ is supplied to the CVD reactor. Therefore, throughout the description in different examples the $Ge_2H_6$ flow values correspond to the diluted digermane flow values (i.e. digermane with a dilution of 1% in $H_2$).

Tin tetrachloride ($SnCl_4$) is a stable and cost efficient precursor.

EXAMPLES

FIG. 1 shows the growth rate of epitaxially grown GeSn as function of the ratio ($SnCl_4$ flow)/($Ge_2H_6$ flow) at 320°C and different total pressures in the reactor (reduced pressure: 10 Torr, 100 Torr; atmospheric pressure-ATM).

In this first example illustrated in FIG. 1 the GeSn layer is overlying and in contact with a Ge buffer layer having a thickness of 50nm on a silicon substrate. As said before, diluted digermane with a dilution of 1% in $H_2$ is supplied to the CVD reactor. In this example 250 sccm $Ge_2H_6$ was employed and the ratio was varied by modifying the $SnCl_4$ flow between 20 sccm and 100 sccm. By modifying the $SnCl_4$ flow and the total pressure in the reactor for a selected value

of the $Ge_2H_6$ flow, different partial pressures of the Sn precursor in the reactor are created. It can be seen that growth rates of the GeSn layer are higher at higher pressures in the CVD reactor. Furthermore, growth rates of the GeSn layer increase with increasing $SnCl_4$ / $Ge_2H_6$ ratio, except for the very low pressures. At such low pressure in the CVD reactor, the partial pressure of $SnCl_4$ may easily become higher than the etch threshold, which results in substrate being removed.

It has been found that the presence of a Ge buffer layer on a silicon substrate improves the growth rate and the quality (crystallinity) of the GeSn grown material. Without intention to be bound by theory, it is assumed that Clx compounds desorb at the growth temperature on Ge surfaces but not, or less, on a Si surface.

When the deposition temperature was 320°C, the growth at higher pressure than 100 Torr resulted in GeSn layer with increased roughness because of the high growth rate.

A smooth GeSn layer was obtained in this first example at 10 Torr total pressure in the reactor. However for $SnCl_4$ flow values higher than a certain value (in this particular example $SnCl_4$/$Ge_2H_6$ flow ratio of about 0.25) a negative growth rate is observed. The value at which the negative growth rate is observed corresponds to an etching threshold of the Sn-partial pressure in the reactor at which the underlying layer (e.g. Ge-buffer layer) starts to be etched.

A GeSn layer grown at 10 Torr total pressure in the reactor, 320°C, with 250 sccm $Ge_2H_6$ and a ($SnCl_4$ flow)/($Ge_2H_6$ flow) ratio of 0.16 had high crystalline quality and a very good (defect free) GeSn/Ge interface, as concluded from cross-section Transmission Electron Microscopy inspection (XTEM).

FIG. 2 shows the X-ray diffraction (XRD) pattern intensity of a monocrystalline GeSn layer epitaxially grown on a Ge buffer layer on a silicon substrate; (1) GeSn-peak, (2) Ge-peak, (3) Si -peak.

In this second example illustrated in FIG. 2 the Ge buffer layer has a thickness of 1 $\mu$m. The GeSn layer is grown at a total pressure of 10 Torr in the reactor and a temperature of 320°C. GeSn layer was grown with a 250 sccm $Ge_2H_6$ flow and a ($SnCl_4$ flow)/($Ge_2H_6$ flow) ratio of 0.16.

FIG. 3 shows the XRD pattern intensity of a monocrystalline GeSn layer epitaxially grown on a Ge buffer layer on a silicon substrate. The GeSn layer was grown with a $SnCl_4$ flow of 40 sccm at a total pressure in the reactor of 10 Torr, at 320°C, with different $Ge_2H_6$ flows: (graph 30) 70 sccm, (graph 31) 125 sccm, (graph 32) 250 sccm, (graph 33) 500sccm.

In this third example illustrated in FIG. 3 the Ge buffer layer has a thickness of 1 $\mu$m. The GeSn layer was grown at different partial pressures of the Sn-precursor in the reactor, by varying the $Ge_2H_6$ flow for a fixed value of the $SnCl_4$ flow (40 sccm) and a fixed total pressure in the reactor (10 Torr).

Surprisingly, the highest substitutional Sn content is obtained for the partial pressure of the Sn-precursor corresponding to the lowest ratio of the range tested at 10 Torr total pressure in the reactor. Rutherford Backscattering spectrometry (RBS) data revealed about 2.9 at% substitutional Sn in the GeSn layer corresponding to the 4th pattern (graph 33) in FIG. 3, i.e. the layer grown with 40 sccm $SnCl_4$ and 500 sccm $Ge_2H_6$ (ratio of 0.08).

Hence in accordance with embodiments of the present invention, higher $Ge_2H_6$ flows help to incorporate more substitutional Sn. Without wishing to be bound by theory it is believed that a higher digermane flow either reduces $SnCl_4$ partial pressure in the reactor and, therefore associated Cl etching effect is diminished and/or enhances the growth rate which permits faster incorporation of Sn than Sn-species desorption. GeSn layers with a very good epitaxial quality (no relaxation defects as threading or misfit dislocations) are obtained.

When lowering the thickness of the GeSn layer (e.g. from 142 nm to 40 nm) no strain induced GeSn peak shift is observed. Both the thin (e.g. 40 nm) and the thick (e.g. 142 nm) GeSn layers grown at low total pressure (e.g. 10 Torr) having relative low amounts of incorporated Sn (e.g. about 3%) are strained. Fringes appeared next to the GeSn peak in the XRD pattern of the thinner layer indicating a smooth defect free GeSn/Ge interface.

FIG. 4 shows the XRD pattern intensity of monocrystalline GeSn layers epitaxially grown on a Ge buffer layer on a silicon substrate. The GeSn layers were grown with a $SnCl_4$ flow of 40 sccm at a total pressure in the reactor of 1 atmosphere (ATM), at 320°C, with different $Ge_2H_6$ flows: (graph 40) 70 sccm, (graph 41) 125 sccm, (graph 42) 250 sccm, (graph 43) 500sccm.

In this fourth example illustrated in FIG.4 the Germanium buffer layer has a thickness of 1 $\mu$m and the GeSn layer a thickness of 240 nm. Increased Sn substitutional incorporation is observed for the 4th pattern (graph 43), at a partial pressure corresponding to 40 sccm $SnCl_4$ and 500 sccm $Ge_2H_6$ at 1 ATM total pressure in the reactor.

First, second and third patterns (graph 40, graph 41, graph 42) in FIG. 4 show a lower epitaxial quality and dissociated XRD peaks for GeSn. Cross-section TEM (Transmission Electron Microscopy) revealed the formation of Sn droplets segregated at the top surface and poly GeSn formation at the interface between Sn droplets and Ge substrates accounting for the two small GeSn XRD associated peaks.

The fourth pattern (graph 43) corresponding to a $Ge_2H_6$ flow of 500 sccm shows only one Sn peak corresponding to substitutional Sn. For the same sample, a cross hatch pattern was revealed under Nomarksi microscope, which is an indication of a plastically relaxed material and a good surface morphology. For the GeSn layer having a thickness of 240 nm, cross-section TEM shows the presence of dislocations within the first 100nm from the interface with the buffer layer. Also a very smooth (low roughness) top surface of the GeSn layer was achieved in this case.

RBS measurements for the GeSn layer corresponding to the fourth XRD pattern (graph 43) in FIG.4 show a substitutional Sn content of about 8 at%.

For thinner GeSn layers (e.g. 40 nm instead of 240 nm in FIG.4) GeSn peak shifted to more negative angles, fringes appeared and the cross hatch in the Nomarski pattern disappeared. This is an indication that the 40 nm GeSn layer was below the critical thickness for plastic relaxation, being fully strained and defect free as confirmed by Reciprocal Space Mapping and XTEM measurements.

The critical thickness for plastic relaxation of the GeSn layers depends on the Sn content and the process conditions during growth. For example, the higher the Sn content in GeSn, the lower the critical thickness of plastic relaxation is for GeSn/Ge.

Further tests with higher values of the $Ge_2H_6$ flow (above 500 sccm) at the selected value (40 sccm) of the $SnCl_4$ flow did not lead to higher Sn incorporation. According to the method of embodiments of the invention a higher Sn incorporation is possible for a higher $SnCl_4$ flow if the $Ge_2H_6$ flow and/or carrier flow and/or total pressure in the CVD reactor are adapted accordingly, such that the partial pressure of the Sn-precursor stays below the etching threshold.

FIG. 5 shows the XRD pattern intensity of a monocrystalline GeSn layer epitaxially grown on a Ge buffer layer on a silicon substrate. The GeSn layer was grown with a $Ge_2H_6$ flow of 500 sccm at a total pressure in the reactor of 1 atmosphere (ATM), at 320°C, with different $SnCl_4$ flows: (graph 50) 5 sccm; (graph 51) 10 sccm; (graph 52) 20 sccm; (graph 53) 40 sccm; (graph 54) 60 sccm.

In this fifth example illustrated in FIG. 5 the Germanium buffer layer has a thickness of 1 $\mu$m. Different partial pressures of the Sn-precursor are investigated by keeping the total pressure in the reactor and the $Ge_2H_6$ flow fixed at its highest value (500 sccm) and varying the $SnCl_4$ flow.

For $SnCl_4$ flows in the range of 5 - 40 sccm, smooth, fully strained GeSn layers having an increasing substitutional Sn content were observed, as shown in FIG. 5. The substitutional Sn content increases from the pattern corresponding to 5 sccm $SnCl_4$ to the pattern corresponding to 40 sccm $SnCl_4$. There is no significant difference observable for 5 and 10 sccm $SnCl_4$, while the pattern corresponding to 60 sccm $SnCl_4$ is indicative for a GeSn layer with a lower quality (crystallinity).

TEM characterization of the GeSn layers described in relation with FIG. 5 (with a $SnCl_4$ flow in the range of 5 - 40 sccm) confirms the GeSn layers quality. In these cases the GeSn layers are single crystalline and have grown in epitaxy with the Ge directly underlying layer, i.e. following the crystalline structure of the directly underlying layer.

Other experiments have been done at 100 Torr, 320°C. It has been observed that when $SnCl_4$ flow was 40 sccm and $Ge_2H_6$ flow was 20 sccm (hence ratio 2:1), there was no growth; when $Ge_2H_6$ flow was larger than 40sccm hence ratio (hence ratio < 1:1) there was GeSn growth. When the $SnCl_4$ flow was 80 sccm and the $Ge_2H_6$ flow is 20 or 40 sccm (hence ratio 4:1 or 2:1) there was no growth, while with a $Ge_2H_6$ flow equal to or larger than 80 sccm (hence ratio < 1:1) there was GeSn growth. When the $SnCl_4$ flow was 200 sccm, and the $Ge_2H_6$ flow 80 or 100sccm, no growth was observed, while with a $Ge_2H_6$ flow equal to or larger than 200 sccm GeSn growth was observed.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

**Claims**

1. A method for depositing a monocrystalline Sn-containing semiconductor material on a substrate comprising a Ge buffer layer, comprising:

   o providing a semiconductor material precursor comprising a germanium-containing precursor, a Sn precursor comprising tin tetrachloride ($SnCl_4$) and a carrier gas in a chemical vapor deposition (CVD) reactor, and

   epitaxially growing the Sn-containing semiconductor material on the substrate, thereby obtaining a monocrystalline material comprising Ge with Sn incorporated in substitutional positions in the lattice, and wherein providing a Sn precursor comprises providing the Sn precursor at a partial pressure of the Sn precursor in the CVD reactor lower than the partial pressure of the Sn-precursor above which no growth occurs anymore or even the substrate or an upper layer thereof starts to be etched,
   wherein epitaxially growing the Sn-containing semiconductor material comprises growing the Sn-containing semiconductor material onto the Ge buffer layer.

2. The method according to claim 1, wherein providing a Sn precursor comprises providing the Sn precursor at a partial pressure in the CVD reactor, whereby for a selected total pressure in the CVD reactor the partial pressure of the Sn precursor is adjusted by modifying at least one of the semiconductor material precursor flow, Sn precursor flow or carrier gas flow in the CVD reactor.

3.  The method according to any of the previous claims, wherein when providing a semiconductor material precursor, a Sn precursor and a carrier gas in a chemical vapor deposition (CVD) reactor a selected total pressure in the CVD reactor is lower than or equal to atmospheric pressure.

4.  The method according to any of the previous claims, wherein providing a semiconductor material precursor comprises providing digermane, trigermane and/or any combinations thereof.

5.  The method according to claim 4, wherein a ratio between $SnCl_4$ flow and $Ge_2H_6$ flow is equal to or lower than 0.2.

6.  The method according to claim 4, wherein the pressure in the reactor is selected below atmospheric pressure, providing a semiconductor material precursor comprises providing $Ge_2H_6$, and a ratio between $SnCl_4$ flow and $Ge_2H_6$ flow is between 0.8 and 1.0.

7.  The method according to any of the previous claims, wherein providing a semiconductor material precursor further comprises providing a silicon precursor.

8.  The method according to any of the previous claims, wherein the epitaxial growth is performed at a temperature between 250°C and 350°C.

9.  The method according to any of the previous claims, further comprising during or after the epitaxial growth introducing dopants in the Sn-containing semiconductor material.

10. The method according to any of the previous claims, wherein the Ge buffer layer has a thickness of 50 nm or 1 $\mu$m on a Silicon substrate.

**Patentansprüche**

1.  Verfahren zum Abscheiden eines monokristallinen Sn-haltigen Halbleitermaterials auf einem Substrat, das eine Ge-Pufferschicht umfasst, umfassend:

    o Bereitstellen eines Halbleitermaterialvorläufers, einen germaniumhaltigen Vorläufer umfassend, eines Sn-Vorläufers, Zinntetrachlorid ($SnCl_4$) umfassend, und eines Trägergases in einem chemischen Dampfabscheidungs-(CVD)-reaktor, und

    epitaxiales Wachsen des Sn-haltigen Halbleitermaterials auf dem Substrat, dadurch Erhalten eines monokristallinen Materials, umfassend Ge mit Sn in Substitutionspositionen im Kristallgitter eingegliedert, und wobei ein Bereitstellen eines Sn-Vorläufers ein Bereitstellen des Sn-Vorläufers bei einem Teildruck des Sn-Vorläufers im CVD-Reaktor umfasst, der geringer ist als der Teildruck des Sn-Vorläufers, über dem kein Wachstum mehr stattfindet oder sogar das Substrat oder eine obere Schicht davon beginnt, geätzt zu werden,
    wobei epitaxiales Wachsen des Sn-haltigen Halbleitermaterials ein Wachsen des Sn-haltigen Halbleitermaterials auf die Ge-Pufferschicht umfasst.

2.  Verfahren nach Anspruch 1, wobei ein Bereitstellen eines Sn-Vorläufers ein Bereitstellen des Sn-Vorläufers bei einem Teildruck im CVD-Reaktor umfasst, wobei für einen ausgewählten Gesamtdruck im CVD-Reaktor der Teildruck des Sn-Vorläufers durch Modifizieren mindestens eines von dem Halbleitermaterialvorläuferdurchsatz, Sn-Vorläuferdurchsatz oder Trägergasdurchsatz im CVD-Reaktor eingestellt wird.

3.  Verfahren nach einem der vorstehenden Ansprüche, wobei, wenn ein Halbleitermaterialvorläufer, ein Sn-Vorläufer und ein Trägergas in einem chemischen Dampfabscheidungs-(CVD)-reaktor bereitgestellt werden, ein ausgewählter Gesamtdruck im CVD-Reaktor geringer als oder gleich atmosphärischem Druck ist.

4.  Verfahren nach einem der vorstehenden Ansprüche, wobei ein Bereitstellen eines Halbleitermaterialvorläufers ein Bereitstellen von Digerman, Trigerman, und/oder beliebige Kombinationen davon umfasst.

5.  Verfahren nach Anspruch 4, wobei ein Verhältnis zwischen $SnCl_4$-Durchsatz und $Ge_2H_6$-Durchsatz gleich oder

geringer als 0,2 ist.

**6.** Verfahren nach Anspruch 4, wobei der Druck im Reaktor unter atmosphärischem Druck ausgewählt ist, ein Bereitstellen eines Halbleitermaterialvorläufers ein Bereitstellen von $Ge_2H_6$ umfasst und ein Verhältnis zwischen $SnCl_4$-Durchsatz und $Ge_2H_6$-Durchsatz zwischen 0,8 und 1,0 ist.

**7.** Verfahren nach einem der vorstehenden Ansprüche, wobei ein Bereitstellen eines Halbleitermaterialvorläufers weiter ein Bereitstellen eines Siliziumvorläufers umfasst.

**8.** Verfahren nach einem der vorstehenden Ansprüche, wobei das epitaxiale Wachstum bei einer Temperatur zwischen 250 °C und 350 °C durchgeführt wird.

**9.** Verfahren nach einem der vorstehenden Ansprüche, weiter umfassend, während oder nach dem epitaxialen Wachstum, ein Einführen von Dotierstoffen in das Sn-haltige Halbleitermaterial.

**10.** Verfahren nach einem der vorstehenden Ansprüche, wobei die Ge-Pufferschicht eine Dicke von 50 nm oder 1 $\mu$m auf einem Siliziumsubstrat aufweist.


## Revendications

**1.** Procédé de dépôt d'un matériau semi-conducteur monocristallin contenant du Sn sur un substrat comprenant une couche tampon de Ge, comprenant les étapes consistant à :

 o fournir un précurseur de matériau semi-conducteur comprenant un précurseur contenant du germanium, un précurseur de Sn comprenant du tétrachlorure d'étain ($SnCl_4$) et un gaz porteur dans un réacteur de dépôt chimique en phase vapeur (CVD), et

 faire croître de manière épitaxiale le matériau semi-conducteur contenant du Sn sur le substrat, en obtenant ainsi un matériau monocristallin comprenant du Ge avec du Sn incorporé dans des positions de substitution dans le réseau, et dans lequel la fourniture d'un précurseur de Sn comprend de fournir le précurseur de Sn à une pression partielle du précurseur de Sn dans le Réacteur de CVD inférieure à la pression partielle du précurseur de Sn au-dessus de laquelle il n'y a plus de croissance ou même le substrat ou une couche supérieure de celui-ci commence à être attaqué,
dans lequel la croissance épitaxiale du matériau semi-conducteur contenant du Sn comprend la croissance du matériau semi-conducteur contenant du Sn sur la couche tampon de Ge.

**2.** Procédé selon la revendication 1, dans lequel la fourniture d'un précurseur de Sn comprend la fourniture du précurseur de Sn à une pression partielle dans le réacteur de CVD, moyennant quoi pour une pression totale sélectionnée dans le réacteur de CVD, la pression partielle du précurseur de Sn est ajustée en modifiant au moins un parmi le flux de précurseur de matériau semi-conducteur, le flux de précurseur de Sn ou le flux de gaz porteur dans le réacteur de CVD.

**3.** Procédé selon l'une quelconque des revendications précédentes, dans lequel lors de la fourniture d'un précurseur de matériau semi-conducteur, d'un précurseur de Sn et d'un gaz porteur dans un réacteur de dépôt chimique en phase vapeur (CVD), une pression totale sélectionnée dans le réacteur de CVD est inférieure ou égale à pression atmosphérique.

**4.** Procédé selon l'une quelconque des revendications précédentes, dans lequel la fourniture d'un précurseur de matériau semi-conducteur comprend la fourniture de digermane, de trigermane et/ou de toute combinaison de ceux-ci.

**5.** Procédé selon la revendication 4, dans lequel un rapport entre un flux de $SnCl_4$ et un flux de $Ge_2H_6$ est égal ou inférieur à 0,2.

**6.** Procédé selon la revendication 4, dans lequel la pression dans le réacteur est choisie inférieure à la pression atmosphérique, la fourniture d'un précurseur de matériau semi-conducteur comprend la fourniture de $Ge_2H_6$, et un rapport entre un flux de $SnCl_4$ et un flux de $Ge_2H_6$ est compris entre 0,8 et 1,0.

7. Procédé selon l'une quelconque des revendications précédentes, dans lequel la fourniture d'un précurseur de matériau semi-conducteur comprend en outre la fourniture d'un précurseur de silicium.

8. Procédé selon l'une quelconque des revendications précédentes, dans lequel la croissance épitaxiale est effectuée à une température comprise entre 250°C et 350°C.

9. Procédé selon l'une quelconque des revendications précédentes, comprenant en outre pendant ou après la croissance épitaxiale l'introduction de dopants dans le matériau semi-conducteur contenant du Sn.

10. Procédé selon l'une quelconque des revendications précédentes, dans lequel la couche tampon de Ge a une épaisseur de 50 nm ou 1 $\mu$m sur un substrat de silicium.

**FIG. 1**

**FIG. 2**

**FIG. 3**

FIG. 4

**FIG. 5**

**EP 2 691 977 B1**

**Patent documents cited in the description**

- WO 2005087983 A
- US 2006163612 A